# EUROPÄISCHE PATENTSCHRIFT

(11) **EP 2 947 668 B1**
(45) Veröffentlichungstag und Bekanntmachung des Hinweises auf die Patenterteilung: **02.08.2023**
(21) Anmeldenummer: 14169258.2
(22) Anmeldetag: 21.05.2014
(51) Int. Cl.: H01F 30/08, G01R 31/14, G01R 31/16

(54) **Stromkreisanordnung für eine Hochspannungsprüfanlage**
Power circuit assembly for a high voltage testing assembly
Circuit pour une installation de contrôle haute tension

(43) Veröffentlichungstag der Anmeldung: 25.11.2015
(73) Patentinhaber: Siemens Energy Global GmbH & Co. KG, 81739 München (DE)
(72) Erfinder: Bock, Markus, 96047 Bamberg (DE)

(56) Entgegenhaltungen:
- EP-A2- 2 587 271
- WINTER A ET AL: "A New Generation of On-Site Test Systems for Power Transformers", ELECTRICAL INSULATION, 2008. ISEI 2008. CONFERENCE RECORD OF THE 2008 IEEE INTERNATIONAL SYMPOSIUM ON, IEEE, PISCATAWAY, NJ, USA, 9. Juni 2008 (2008-06-09), Seiten 478-482, XP031464737, ISBN: 978-1-4244-2091-9
- Wolfgang Hauschild ET AL: "Static Frequency Converters for Factory and Field Testing of Power Transformers by Induced Voltages", Transformer Committee, Fall Meeting 2010, Toronto, Canada, 28. Oktober 2010 (2010-10-28), Seiten 1-15, XP055137249, Gefunden im Internet: URL:http://grouper.ieee.org/groups/transfo rmers/subcommittees/standardsc/WG_C57.152/ F10-CP57.152-Presentation.pdf [gefunden am 2014-08-29]
- WINTER A ET AL: "A Mobile Transformer Test System Based on a Static Frequency Converter", INTERNATIONAL SYMPOSIUM ON HIGH VOLTAGE ENGINEERING, XX, XX, 27. August 2007 (2007-08-27), Seiten 1-6, XP007906020,
- KONGNUN W ET AL: "A positive reference PWM strategy based on multi-switching DC voltage sources converter for insulation testing", IECON 2010 - 36TH ANNUAL CONFERENCE ON IEEE INDUSTRIAL ELECTRONICS SOCIETY, IEEE, PISCATAWAY, NJ, USA, 7. November 2010 (2010-11-07), Seiten 309-314, XP031840123, ISBN: 978-1-4244-5225-5
- HUANG XIXIA ET AL: "Research on Harmonic Suppression of Shore-side Marine Power System of Frequency Conversion", ENERGY PROCEDIA, Bd. 13, 2011, Seiten 4536-4545, XP028469844, ISSN: 1876-6102, DOI: 10.1016/J.EGYPRO.2011.12.054 [gefunden am 2012-03-15]
- "International Standard IEC 60270. High-voltage test techniques - Partial discharge measurements", , 21 December 2000 (2000-12-21), pages 1-99, XP055225178, International Electrotechnical Commission, 3, rue de Varemb? Geneva, Switzerland Retrieved from the Internet: URL:www.standards.org [retrieved on 2015-11-02]

## Beschreibung

Die Erfindung betrifft eine Stromkreisanordnung für eine Hochspannungsprüfanlage.

Zum Betrieb einer Hochspannungsprüfanlage werden häufig Wechselspannungen mit von einer Netzfrequenz abweichenden Frequenzen benötigt. Beispielsweise ist dies bei so genannten Resonanzprüfanlagen, die Hochspannungsdrosseln aufweisen, zum Einstellen einer Resonanzfrequenz, welche von der Kapazität des jeweiligen Prüflings abhängt, der Fall, und auch bei Prüfanlagen mit Prüftransformatoren für Spannungswandlerprüfungen induktiver Spannungswandler, um durch eine erhöhte Prüfungsfrequenz die Sättigung des Prüflings zu vermeiden.

Bei Resonanzprüfanlagen werden üblicherweise elektronische Umrichter eingesetzt, um eine einstellbare Anregungsfrequenz und eine ausreichende Leistung zu erzeugen. Ein derartiger Umrichter erzeugt üblicherweise mittels einer Pulsweitenmodulation ein Rechtecksignal, dessen Frequenz und Pulsbreite einstellbar sind. Die Rechtecksignalfrequenz wird auf die Resonanzfrequenz des jeweiligen Prüfaufbaus eingestellt. Durch Verändern der Rechtecksignalbreite erfolgt die Regelung der Hochspannung im Resonanzkreis. Die Rechteckspannung führt dem Resonanzkreis Energie zu. Bei ausreichender Resonanzkreisgüte wird die Resonanzspannung trotz der Rechteckanregung annähernd sinusförmig. Die Rechteckkurvenform wird üblicherweise verwendet, da sie einfach und mit geringen Verlusten elektronisch generiert werden kann.

Zur Reduzierung thermischer Verluste in den Halbleiterschaltern sind die Schaltflanken der Rechteckimpulse vergleichsweise steil (typisch sind beispielsweise Schaltzeiten von etwa 200 ns). Das Frequenzspektrum der Rechtecksignale enthält daher entsprechend hochfrequente Anteile. Insbesondere können dabei Anteile in Frequenzbereichen auftreten, die für hochempfindliche Teilentladungsmessungen vorgesehen sind, beispielsweise in dem Frequenzbereich von 30 kHz bis 1 MHz, der von der Norm IEC 60270 (IEC = International Electrotechnical Commission) für Teilentladungsmessungen vorgesehen ist. Daher können die hochfrequenten Anteile des Frequenzspektrums der Rechtecksignale Teilentladungsmessungen stören.

Um derartige Störungen von Teilentladungsmessungen zu vermeiden, sind verschiedene Methoden bekannt. Eine derartige Methode besteht darin, bestimmte Phasenbereiche, in denen Störungen auftreten, bei den Teilentladungsmessungen auszublenden (so genanntes "Gating"). Dadurch werden die Teilentladungsmessungen in den ausgeblendeten Phasenbereichen jedoch blind, d. h. Teilentladungsfehler eines Prüflings in diesen Phasenbereichen werden nicht erfasst. Bei einer anderen Methode werden Filter hinter dem elektronischen Umrichter eingesetzt, was erfahrungsgemäß aufgrund der hohen Empfindlichkeit der Teilentladungsmessungen und der spektralen Intensität der Umrichterimpulse sehr aufwändig ist. Eine weitere Methode besteht darin, eine sinusförmige Anregungswechselspannung zu verwenden. Diese kann entweder mittels elektronischer Sinusquellen oder mittels rotierender Umformer erzeugt werden. Elektronische Sinusquellen haben jedoch einen sehr schlechten Wirkungsgrad und bewirken daher hohe Energieverluste. Rotierende Umformer sind groß, schwer, teuer und inzwischen schwierig zu beschaffen. Als Stand der Technik sei die Patentanmeldung EP2587271 A2, sowie das Dokument WINTER A. ET AL: "A Mobile Transformer Test System Based on a Static Frequency Converter",INTERNATIONAL SYMPOSIUM ON HIGH VOLTAGE ENGINEERING 27. August 2007 (2007-08-27), Seiten 1-6 genannt.

Der Erfindung liegt die Aufgabe zugrunde, eine verbesserte Stromkreisanordnung für eine Hochspannungsprüfanlage anzugeben.

Die Aufgabe wird erfindungsgemäß hinsichtlich der Stromkreisanordnung durch die Merkmale des Anspruchs 1 gelöst.

Vorteilhafte Ausgestaltungen der Erfindung sind Gegenstand der Unteransprüche.

Eine erfindungsgemäße Stromkreisanordnung für eine Hochspannungsprüfanlage umfasst eine elektronische Stromrichtereinheit zur Erzeugung einer Anregungswechselspannung mit einer einstellbaren Grundfrequenz und einem Frequenzspektrum, dessen Amplituden innerhalb eines vorgegebenen Frequenzbereichs einen vorgebbaren Amplitudenschwellenwert unterschreiten.

Unter einer Anregungswechselspannung wird hier die von der Stromrichtereinheit erzeugte Wechselspannung verstanden. Die Anregungswechselspannung unterscheidet sich von der Prüfungswechselspannung, die an einem Prüfling anliegt, der zur Hochspannungsprüfung in die Stromkreisanordnung geschaltet wird. In einer als Resonanzprüfanlage ausgebildeten Hochspannungsprüfanlage kann die Prüfungswechselspannung beispielsweise selbst bei einer rechteckförmigen Anregungswechselspannung annähernd sinusförmig sein, wenn die Grundfrequenz der Anregungswechselspannung mit der Resonanzfrequenz der den Prüfling enthaltenden Stromkreisanordnung übereinstimmt.

Eine erfindungsgemäße Stromkreisanordnung ermöglicht insbesondere vorteilhaft, mittels der elektronischen Stromrichtereinheit Anregungswechselspannungen zu erzeugen, deren Grundfrequenz einstellbar ist und deren Frequenzspektren keine Amplituden enthalten, die Teilentladungsmessungen stören. Für Teilentladungsmessungen brauchen also keine störenden Phasenbereiche ausgeblendet oder Filter für die Stromrichtersignale eingesetzt werden. Dies wird ferner vorteilhaft mittels einer elektronischen Stromrichtereinheit statt mittels eines großen und teuren rotierenden Umformers erreicht. Die Erfindung ermöglicht also eine vergleichsweise einfache und kostengünstige Realisierung von Hochspannungsprüfanlagen mit Wechselspannungen einstellbarer Frequenz, ohne Teilentladungsmessungen zu beeinträchtigen.

Eine Ausgestaltung der Erfindung sieht dementsprechend vor, dass der vorgegebene Frequenzbereich wenigstens einen für eine Teilentladungsmessung vorgesehenen Frequenzbereich enthält.

Die Erfindung sieht vor, dass der vorgegebene Frequenzbereich die Frequenzen von 30 kHz bis 1 MHz enthält.

Ein Verschwinden des Frequenzspektrums in dem Frequenzbereich von 30 kHz bis 1 MHz ist besonders vorteilhaft, da dieser Frequenzbereich in der oben bereits erwähnten Norm IEC 60270 für Teilentladungsmessungen vorgesehen ist.

Die Erfindung sieht vor, dass das Frequenzspektrum nur bei der Grundfrequenz und einer begrenzten Anzahl von Vielfachen der Grundfrequenz wesentliche Amplituden aufweist.

Die Erfindung nutzt aus, dass ein Frequenzspektrum, das außer bei der Grundfrequenz nur bei wenigen Vielfachen (beispielsweise bei dem Dreifachen, Fünffachen und Siebenfachen) der Grundfrequenz wesentliche Amplituden aufweist, bereits eine annähernd rechteckförmige oder trapezförmige Signalform liefern kann. Eine Anregungswechselspannung einer derartigen Signalform hat gegenüber einer rein sinusförmigen Anregungswechselspannung den Vorteil, dass sie sich mittels analoger Leistungselektronik erheblich verlustärmer erzeugen lässt. Annähernd trapezförmige Signalformen haben den zusätzlichen Vorteil, die Auswirkungen des so genannten Gibbsschen Phänomens (Überschwingungen der addierten Fourierkomponenten des Signals an dessen Sprungstellen mit einer relativen Auslenkung von ca. 9 %) zu vermeiden. Ferner nutzt diese Ausgestaltung aus, dass die bei Hochspannungsprüfungen verwendeten Grundfrequenzen, insbesondere die für Resonanzsysteme typischen Resonanzfrequenzen im Bereich bis etwa 300 Hz, in der Regel deutlich kleiner als die für Teilentladungsmessungen vorgesehenen Frequenzen sind, so dass die besonders bevorzugten kleinen Vielfachen der Grundfrequenz in der Regel unterhalb des für Teilentladungsmessungen vorgesehenen Frequenzbereiches liegen.

Eine weitere Ausgestaltung der Erfindung sieht wenigstens eine Hochspannungsdrossel vor.

Dadurch eignet sich die Stromkreisanordnung als Resonanzsystem für eine als Resonanzprüfanlage ausgebildete Hochspannungsprüfanlage. In einem derartigen Resonanzsystem wird ein kapazitiver Prüfling in Reihe mit der wenigstens einen Hochspannungsdrossel geschaltet, so dass der Prüfling und die wenigstens eine Hochspannungsdrossel einen Resonanzkreis bilden. Dies hat den Vorteil, dass die für die Hochspannungsprüfung benötigte Prüfungswechselspannung mit einer deutlich (typisch um einen Faktor 20 bis 100) kleineren Anregungswechselspannung erzeugt werden kann, wenn die Grundfrequenz auf die Resonanzfrequenz des Resonanzkreises eingestellt wird. Ein weiterer Vorteil ist, dass bei der Einstellung der Grundfrequenz auf die Resonanzfrequenz die Prüfungswechselspannung üblicherweise (d. h. bei typischen Gütefaktoren des Resonanzkreises) durch das Resonanzprinzip bedingt und unabhängig von der Form der Anregungswechselspannung annähernd sinusförmig ist.

Dementsprechend sieht eine Weitergestaltung der vorgenannten Ausgestaltung der Erfindung vor, dass die Grundfrequenz auf eine Resonanzfrequenz der einen Prüfling enthaltenden Stromkreisanordnung einstellbar ist.

Weitere Ausgestaltungen der Erfindung sehen eine als ein Vierquadrantenverstärker oder als ein Zweiquadrantenverstärker ausgebildete elektronische Stromrichtereinheit vor.

Derartig ausgebildete Stromrichtereinheiten eignen sich besonders vorteilhaft zur Erzeugung einer Anregungswechselspannung mit einem oben bereits erwähnten vorteilhaften Frequenzspektrum, das nur bei der Grundfrequenz und einer begrenzten Anzahl von Vielfachen der Grundfrequenz wesentliche Beiträge hat. Im Falle eines Resonanzprüfsystems kann dabei ferner ein Vier- oder Zweiquadrantenverstärker ohne einen sonst üblichen Isoliertransformator verwendet werden, da die Spannungseinspeisung bei Resonanzprüfsystemen erdgebunden erfolgen kann.

Eine weitere, zu den beiden vorgenannten Ausgestaltungen alternative Ausgestaltung der Erfindung sieht eine als ein Umrichter ausgebildete elektronische Stromrichtereinheit vor.

Gegenüber den vorgenannten Ausbildungen der Stromrichtereinheit als Vier- oder Zweiquadrantenverstärker hat die Ausbildung als Umrichter den Vorteil, kostengünstiger zu sein.

Dabei weist der Umrichter vorzugsweise elektronische Schaltelemente zur Erzeugung der Anregungswechselspannung auf, deren Schaltflanken keine Beiträge zu dem Frequenzspektrum in dem vorgegebenen Frequenzbereich liefern.

Gegenüber üblicherweise verwendeten Umrichtern wird die Steilheit der Schaltflanken der Schaltelemente dabei soweit reduziert, dass das Frequenzspektrum dadurch keine Beiträge in dem vorgegebenen Frequenzbereich erhält. Durch die Reduzierung der Steilheit der Schaltflanken nehmen zwar die thermischen Verluste der Schaltelemente zu. Diese Zunahme ist jedoch aufgrund der typischen bei Hochspannungsprüfungen verwendeten relativ niedrigen Grundfrequenzen im Bereich bis etwa 300 Hz moderat und daher tolerierbar.

Eine weitere Ausgestaltung der Erfindung sieht vor, dass die elektronische Stromrichtereinheit für elektrische Leistungen im Bereich zwischen 10 kVA und 100 kVA ausgelegt ist.

Derartige Auslegungen der Stromrichtereinheit sind besonders vorteilhaft, da Leistungen im Bereich zwischen 10 kVA und 100 kVA typisch für Hochspannungsprüfanlagen sind.

Eine erfindungsgemäße Hochspannungsprüfanlage weist eine erfindungsgemäße Stromkreisanordnung mit den genannten Vorteilen auf.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit einer Zeichnung näher erläutert werden.

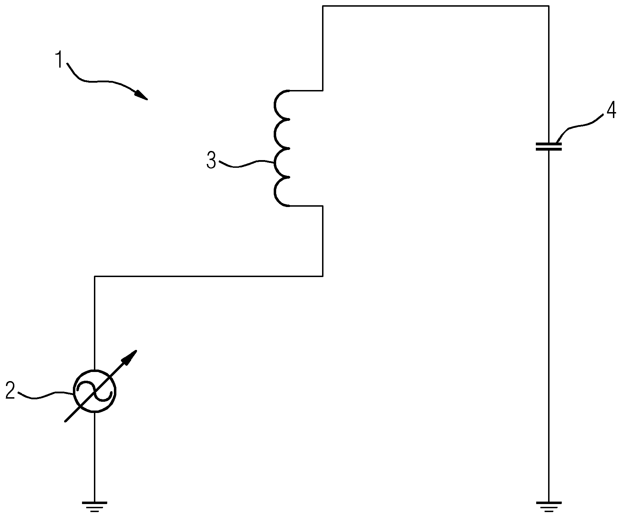

Dabei zeigt die einzige Figur schematisch eine Stromkreisanordnung 1 für eine Hochspannungsprüfanlage. Die Stromkreisanordnung 1 weist eine elektronische Stromrichtereinheit 2 und eine Hochspannungsdrossel 3 auf. Ferner ist ein Prüfling 4 dargestellt, der mit der Hochspannungsdrossel 3 elektrisch in Reihe geschaltet ist. Der Prüfling 4 ist dabei als Kondensator dargestellt, da er sich bei der Hochspannungsprüfung in der Regel wie ein Kondensator verhält.

Die elektronische Stromrichtereinheit 2 ist zur Erzeugung einer Anregungswechselspannung mit einer einstellbaren Grundfrequenz und einem Frequenzspektrum, dessen Amplituden innerhalb eines vorgegebenen Frequenzbereichs einen vorgebbaren Amplitudenschwellenwert unterschreiten, ausgebildet. Dieser Frequenzbereich wird dabei so vorgegeben, dass er einen für eine Teilentladungsmessung vorgesehenen Frequenzbereich, beispielsweise von 30 kHz bis 1 MHz, enthält.

Gemäß einem ersten Ausführungsbeispiel ist die elektronische Stromrichtereinheit 2 als ein Vierquadrantenverstärker ausgebildet, der eine Anregungswechselspannung mit einem Frequenzspektrum erzeugt, das nur bei der Grundfrequenz und einer begrenzten Anzahl von Vielfachen der Grundfrequenz, beispielsweise bei dem bei dem Dreifachen, Fünffachen und Siebenfachen der Grundfrequenz, wesentliche Beiträge aufweist.

Gemäß einem zweiten Ausführungsbeispiel ist die elektronische Stromrichtereinheit 2 als ein Zweiquadrantenverstärker ausgebildet, der eine Anregungswechselspannung mit einem Frequenzspektrum erzeugt, das ebenfalls nur bei der Grundfrequenz und einer begrenzten Anzahl von Vielfachen der Grundfrequenz, beispielsweise bei dem bei dem Dreifachen, Fünffachen und Siebenfachen der Grundfrequenz, wesentliche Beiträge aufweist.

Gemäß einem dritten Ausführungsbeispiel ist die elektronische Stromrichtereinheit 2 als ein Umrichter ausgebildet. Der Umrichter weist Schaltelemente zur Erzeugung der Anregungswechselspannung auf, deren Beschaltung und/oder Gateansteuerung derart ausgebildet ist, dass ihre Schaltflanken keine Beiträge zu dem Frequenzspektrum in dem vorgegebenen Frequenzbereich liefern.

Die Hochspannungsdrossel 3 kann einen Eisenkern aufweisen und beispielsweise ölisoliert ausgeführt sein. Alternativ kann die Hochspannungsdrossel 3 als Luftspule ausgebildet und beispielsweise gasisoliert sein.

Die Hochspannungsdrossel 3 und der Prüfling 4 sowie gegebenenfalls weitere, hier nicht dargestellte elektrische Komponenten, wie z. B. ein Koppelkondensator für Teilentladungsmessungen oder ein Messteiler zur Spannungsmessung, bilden einen Resonanzkreis mit einer Resonanzfrequenz, die typisch zwischen 20 Hz und 300 Hz liegt.

Bei der Hochspannungsprüfung wird die Grundfrequenz der Anregungswechselspannung auf die Resonanzfrequenz des Resonanzkreises eingestellt.

Obwohl die Erfindung im Detail durch bevorzugte Ausführungsbeispiele näher illustriert und beschrieben wurde, so ist die Erfindung nicht durch die offenbarten Beispiele eingeschränkt.

## Patentansprüche

1. Stromkreisanordnung (1) für eine Hochspannungsprüfanlage, umfassend eine elektronische Stromrichtereinheit (2) zur Erzeugung einer Anregungswechselspannung mit einer einstellbaren Grundfrequenz und einem Frequenzspektrum,
**dadurch gekennzeichnet, dass**
die Amplituden des Frequenzspektrums innerhalb eines vorgegebenen Frequenzbereichs einen vorgebbaren Amplitudenschwellenwert unterschreiten, wobei der vorgegebene Frequenzbereich die Frequenzen von 30 kHz bis 1 MHz enthält, und das Frequenzspektrum nur bei der Grundfrequenz und einer begrenzten Anzahl von Vielfachen der Grundfrequenz wesentliche Amplituden aufweist.

2. Stromkreisanordnung (1) nach Anspruch 1,
**dadurch gekennzeichnet, dass** der vorgegebene Frequenzbereich wenigstens einen für eine Teilentladungsmessung vorgesehenen Frequenzbereich enthält.

3. Stromkreisanordnung (1) nach einem der vorhergehenden Ansprüche,
**gekennzeichnet durch** wenigstens eine Hochspannungsdrossel (3).

4. Stromkreisanordnung (1) nach Anspruch 3,
**dadurch gekennzeichnet, dass** die Grundfrequenz auf eine Resonanzfrequenz der einen Prüfling (4) enthaltenden Stromkreisanordnung (1) einstellbar ist.

5. Stromkreisanordnung (1) nach einem der vorhergehenden Ansprüche,
**gekennzeichnet durch** eine als ein Vierquadrantenverstärker ausgebildete elektronische Stromrichtereinheit (2).

6. Stromkreisanordnung (1) nach einem der Ansprüche 1 bis 4,
**gekennzeichnet durch** eine als ein Zweiquadrantenverstärker ausgebildete elektronische Stromrichtereinheit (2).

7. Stromkreisanordnung (1) nach einem der Ansprüche 1 bis 4,
**gekennzeichnet durch** eine als ein Umrichter ausgebildete elektronische Stromrichtereinheit (2).

8. Stromkreisanordnung (1) nach Anspruch 7,
**dadurch gekennzeichnet, dass** der Umrichter elektronische Schaltelemente zur Erzeugung der Anregungswechselspannung aufweist, deren Schaltflanken keine Beiträge zu dem Frequenzspektrum in dem vorgegebenen Frequenzbereich liefern.

9. Stromkreisanordnung (1) nach einem der vorhergehenden Ansprüche,
**dadurch gekennzeichnet, dass** die elektronische Stromrichtereinheit (2) für elektrische Leistungen im Bereich zwischen 10 kVA und 100 kVA ausgelegt ist.

10. Hochspannungsprüfanlage mit einer Stromkreisanordnung (1) nach einem der vorhergehenden Ansprüche.

## Claims

1. Circuit arrangement (1) for a high-voltage test installation, comprising an electronic converter unit (2) for generating a stimulus AC voltage having an adjustable fundamental frequency and a frequency spectrum,
**characterized in that**
the amplitudes of the frequency spectrum are below a prescribable amplitude threshold value within a prescribed frequency range, wherein the prescribed frequency range contains the frequencies from 30 kHz to 1 MHz, and the frequency spectrum has amplitudes that are essential only at the fundamental frequency and at a limited number of multiples of the fundamental frequency.

2. Circuit arrangement (1) according to Claim 1,
**characterized in that** the prescribed frequency range contains at least one frequency range provided for a partial discharge measurement.

3. Circuit arrangement (1) according to either of the preceding claims,
**characterized by** at least one high-voltage inductor (3).

4. Circuit arrangement (1) according to Claim 3,
**characterized in that** the fundamental frequency is adjustable to a resonant frequency of the circuit arrangement (1) containing a device under test (4).

5. Circuit arrangement (1) according to one of the preceding claims,
**characterized by** an electronic converter unit (2) in the form of a four-quadrant amplifier.

6. Circuit arrangement (1) according to one of Claims 1 to 4,
**characterized by** an electronic converter unit (2) in the form of a two-quadrant amplifier.

7. Circuit arrangement (1) according to one of Claims 1 to 4,
**characterized by** an electronic converter unit (2) in the form of a converter.

8. Circuit arrangement (1) according to Claim 7,
**characterized in that** the converter has electronic switching elements for generating the stimulus AC voltage, the switching edges of which make no contribution to the frequency spectrum in the prescribed frequency range.

9. Circuit arrangement (1) according to one of the preceding claims,
**characterized in that** the electronic converter unit (2) is designed for electrical powers in the range between 10 kVA and 100 kVA.

10. High-voltage test installation having a circuit arrangement (1) according to one of the preceding claims.

## Revendications

1. Montage (1) de circuit pour une installation de contrôle en haute tension, comprenant une unité (2) électronique de convertisseur de production d'une tension alternative d'excitation ayant une fréquence fondamentale réglable et un spectre de fréquence,
**caractérisé en ce que**
les amplitudes du spectre de fréquence n'atteignent pas, dans un domaine de fréquence donné à l'avance, une valeur de seuil d'amplitude pouvant être donnée à l'avance, dans lequel le domaine de fréquence donné à l'avance contient les fréquences de 30 kHz à 1 MHz, et le spectre de fréquence n'a des amplitudes sensibles qu'à la fréquence fondamentale et qu'à un nombre limité de multiples de la fréquence fondamentale.

2. Montage (1) de circuit suivant la revendication 1,
**caractérisé en ce que** le domaine de fréquence donné à l'avance contient au moins un domaine de fréquence prévu pour une mesure de décharge partielle.

3. Montage (1) de circuit suivant l'une des revendications précédentes,
**caractérisé par** au moins une bobine (3) de haute tension.

4. Montage (1) de circuit suivant la revendication 3,
**caractérisé en ce que** la fréquence fondamentale est réglable sur une fréquence de résonnance du montage (1) de circuit contenant un échantillon (4).

5. Montage (1) de circuit suivant l'une des revendications précédentes,
**caractérisé par** une unité (2) électronique de convertisseur constituée sous la forme d'un amplificateur à quatre cadrans.

6. Montage (1) de circuit suivant l'une des revendications 1 à 4,
**caractérisé par** une unité (2) électronique de convertisseur constituée sous la forme d'un amplificateur à deux cadrans.

7. Montage (1) de circuit suivant l'une des revendications 1 à 4,
**caractérisé par** une unité (2) électronique de convertisseur constituée sous la forme d'un onduleur.

8. Montage (1) de circuit suivant la revendication 7,
**caractérisé en ce que**
l'onduleur a des éléments électroniques de coupure de production de la tension alternative d'excitation, dont les flancs de coupure ne fournissent pas de contribution au spectre de fréquence dans le domaine de fréquence donné à l'avance.

9. Montage (1) de circuit suivant l'une des revendications précédentes,
**caractérisé en ce que**
l'unité (2) électronique de convertisseur est conçue pour des puissances électriques dans la plage comprise entre 10 kVA et 100 kVA.

10. Installation de contrôle en haute tension comprenant un montage (1) de circuit suivant l'une des revendications précédentes.
